# EUROPEAN PATENT APPLICATION

(11) **EP 1 330 146 A2**
(43) Date of publication of application: **23.07.2003**
(21) Application number: 03250245.2
(22) Date of filing: 15.01.2003
(51) Int. Cl.: H05K 3/42, H05K 3/46

(54) **Via filling method**

(30) Priority: 15.01.2002 JP 2002006183
(71) Applicant: Shipley Co. L.L.C., Marlborough, MA 01752 (US)
(72) Inventor: Tsuchida, Hideki, Hasuda-shi, Saitama 349-0127 (JP); Kusaka, Masaru, Kitaadachi-gun, Saitama 362-0806 (JP)
(74) Representative: Kent, Venetia Katherine

(57) **Abstract**

A process for via filling is provided, wherein after flash plating, a PPR current is applied for a cycle of 1 to 50 msec positive electrolysis time and 0.2 to 5 msec reverse electrolysis time until an F/R ratio representing the ratio of positive electrolysis current density to reverse electrolysis current density is at least 1/0.2 and less than 1/1.

## Description

### Background of the Invention

This invention provides a novel via filling process. More particularly, this invention provides a novel via filling process that produces superior filling and superior flatness.

In recent years, there has been a strong demand for higher density and thinner printed circuit boards in response to greater high performance and miniaturization of electronic devices, beginning with personal computers. One means responding to such demands is to use a multilayer printed circuit board (build-up printed circuit board) produced using the build-up method of forming a pattern for each layer and laminating successive layers.

A process for completely filling micro via holes (hereafter sometimes called "MVH") with a conductor and electrically connecting between adjacent layers of a build-up printed circuit board has been developed for such build-up printed circuit boards in recent years. This method, called via-filling, can increase the effective surface area of the printed circuit board and obtain adequate electrical connections even in MVH having a smaller diameter compared to plating only the inner wall of MVH by prior art methods, and is effective for miniaturizing and increasing the density of printed circuit boards.

Processes published as via filling processes include the process of filling MVH with a conductive paste by the printing method, the method of selectively building up electroless plating by activating only a conductive layer on the floor of MVH, and methods using electroplating.

Being a mixture of organic substances, however, conductive paste has low conductivity compared to pure metals, has difficulty forming adequate electrical connections in small-diameter MVH, and cannot be called an effective method for miniaturizing and increasing the density of printed circuit boards. Moreover, filling by the printing method requires packing a viscous paste into holes that are impassable due to their small diameter, and has difficulty filling holes completely without leaving voids due to the viscosity of the paste. The method of using electroless plating is superior to the conductive paste method on the point that the substance filling MVH is a highly conductive metallic deposit, but has a slow plating film deposition speed, which is a problem for productivity. For example, the plating speed using a general-purpose high-speed electroless copper plating bath is about 3 µm/hr, but filling blind via holes (hereafter sometimes called "BVH") that are typically 100 µm in diameter and 100 µm deep by copper plating using this bath takes 30 hours or longer, making this extremely poor in productivity.

Because electroplating can substantially reduce time compared to electroless plating, electroplating is expected to be applied to MVH. When depositing a metal over the entire inner surface of MVH, however, the plating speed near the floor inside MVH must be faster than the plating speed at the opening in order to fill MVH with metal without leaving voids. If the plating speed near the floor is the same as or slower than the plating speed at the opening, the MVH are not filled or the opening becomes clogged before MVH are completely filled with metal plating, leaving voids inside. In either case, the MVH are inadequate for practical application. Therefore, filling conditions must be strictly controlled to enable the optimum deposition of metal for filling micro via holes.

Direct-current electrolysis is generally used as a condition of electrolysis when using an electroless plating bath in prior art to accelerate the plating speed near the floor inside MVH. The method of using PR (periodic reverse) electrolysis alternating the cathode and the anode is also known, but this has an extremely long cycle of several seconds to several tens of seconds, and is not able to satisfactorily control the plating speed of metal.

In addition, the filled surface is not flat, producing an indented shape at the center of via. As a result, when filled to an adequate height, the plating film thickens on the outside of the via, which causes great inconvenience during later treatments and is economically undesirable.

One method for improving via filling, disclosed by Japanese Unexamined Patent Application No. 2000-68651, is the method of applying electrolytic copper plating using a plating bath containing a particular compound containing sulfur ions and a PPR (pulse periodic reverse) current. However, although adsorption and desorption of the particular compound containing sulfur ions to the substrate is controlled by the invention disclosed in this patent application, stricter control of plating conditions is required to fill micro via holes having a high aspect ratio.

### Summary of the Invention

Reflecting on the situation outlined above, the purpose of this invention is to offer a novel via filling process that produces a surface having superior filling and flatness in a short time.

This invention offers a via filling process wherein after flash plating, a PPR current is applied for a cycle of 1 to 50 msec positive electrolysis time and 0.2 to 5 msec reverse electrolysis time until an F/R ratio representing the ratio of positive electrolysis current density to reverse electrolysis current density is from 1/0.2 to 1/1.

### Brief Description of the Invention

Figs. 1A-1E illustrate cross-sectional views of vias plated according to the invention, not to scale.
Figs. 2A-2E illustrate cross-sectional views of vias plated according to comparative methods, not to scale.

### Detailed Description of the Invention

"Positive electrolysis time" means the time during which electrolysis is applied using the plating object as a cathode, and "reverse electrolysis time" means the time during which electrolysis is applied using the plating object as an anode. Positive electrolysis time and reverse electrolysis time can be changed according to plating conditions such as the opening diameter of the MVH to be filled, the aspect ratio, and the type of metal used for filling. A wide range of both positive electrolysis times and reverse electrolysis times may be used. Positive electrolysis time is typically 1 to 50 msec, preferably 5 to 30 msec, and more preferably 10 to 20 msec. Reverse electrolysis time is typically 0.2 to 5 msec, preferably 0.2 to 2 msec, and more preferably 0.2 to 1 msec.

Less than 0.2 msec positive electrolysis time may not be efficient because electrolysis stops before metal has started to deposit properly. Greater than 50 msec positive electrolysis time may increase the adsorption of grain refiner near the openings of blind via holes when using the grain refiner described below, with the result that the plating speed near the floor of blind via holes may not be faster than the plating speed at the opening, and satisfactory filling cannot be obtained.

Less than 0.2 msec reverse electrolysis time may lead to adsorption of grain refiner near the openings of blind via holes when using the grain refiner described below, with the result that the plating speed near the floor of blind via holes may not be faster than the plating speed at the opening, and satisfactory filling may not be obtained. Greater than 5 msec reverse electrolysis time is undesirable because the metallic film already deposited dissolves, lengthening the time required to fill blind via holes.

Typically, positive electrolysis is applied at a current density of 0.1 to 20 A/dm², and preferably 0.1 to 10 A/dm². In general, reverse electrolysis is applied at a current density of 0.1 to 200 A/dm², and preferably 0.1 to 100 A/dm².

In this specification, the ratio of current density during positive electrolysis to current density during reverse electrolysis is called the F/R ratio. That is, the level of reverse electrolysis current density R when positive electrolysis current density F is 1 is called the F/R ratio, and is lower when F/R = 1/1 than when F/R = 1/2. In this invention, the F/R ratio is preferably in a range from 1/0.2 to 1/0.9, and more preferably a range from 1/0.4 to 1/0.6. Most typically, the F/R ratio is 1/0.5.

In this invention, a metallic layer is deposited on the inner wall of via holes ahead of time as a pretreatment before filling by PPR electrolysis, and the via filling method described above is executed after assuring that this is conductive. Such flash plating can be performed by any of direct-current electrolysis, pulse electrolysis, or PPR electrolysis. That is, this invention further offers the following three modes:
i) The method of executing the via filling process of this invention after flash plating by direct-current electrolysis
ii) The method of executing the via filling process of this invention after flash plating by pulse electrolysis
iii) The method of executing the via filling process of this invention after flash plating by PPR electrolysis.

"Direct-current electrolysis" refers to electroplating using a direct-current power source. Electrolysis conditions such as current or time and plating solution compositions are well-known, and can be determined as appropriate by persons skilled in the art.

"Pulse electrolysis" refers to electroplating using a pulse power source; that is, under the electrolysis condition of alternating between positive electrolysis time and rest time in pulses. Electrolysis conditions such as current or time and plating solution compositions are well-known, and can be determined as appropriate by persons skilled in the art.

PPR electrolysis for flash plating is typically performed by applying a PPR current for a cycle of 1 to 50 msec positive electrolysis time and 0.2 to 5 msec reverse electrolysis time until the F/R ratio is in a range of 1/1 to 1/10.

Flash plating is performed by any of these methods until a metal has been deposited over the entire inner wall of via holes and adequate conductivity has been obtained. The thickness of the metallic film after flash plating is completed is typically 0.5 to 5 micrometers.

When via holes have a high aspect ratio, the method using PPR electrolysis is preferred because of its superior wrapping ability. In addition, where direct-current electrolysis requires two plating tanks because the plating solution composition used for direct-current electrolysis is different from the plating solution composition used for PPR electrolysis, PPR electrolysis uses only one plating tank and all steps can be performed simply by varying electrolysis conditions. Therefore, PPR electrolysis is more convenient in terms of operation and more useful in terms of economy. However, direct-current electrolysis and PPR electrolysis also can be performed in the same plating tank depending on the bath composition.

Preferably, a rest time is inserted in PPR electrolysis in this invention. In this invention, "rest time" means the time during which electrolysis is not applied. The rest time may be inserted during the change from positive electrolysis to reverse electrolysis or during the change from reverse electrolysis to reverse electrolysis, and may be inserted during both times. Preferably, however, the rest time is inserted during the change from reverse electrolysis to positive electrolysis. It is considered that inserting such a rest time produces a satisfactory filling result by supplying metallic ions for plating inside the via.

A wide range of rest times may be used. The rest time is typically 0.1 to 20 msec, preferably 0.5 to 5 msec, and more preferably 0.5 to 1 msec.

A rest time can be inserted in all PPR electrolysis; that is, in both the PPR electrolysis used in the via filling method of this invention and the PPR electrolysis used in flash plating.

In a particular embodiement, a PPR current can be applied in this invention for a cycle of 1 to 50 msec positive electrolysis time, 0.2 to 5 msec reverse electrolysis time, and 0.1 to 20 msec rest time.

The process of this invention is useful for filling depressions having a high aspect ratio, such as via holes, with metal. The method of this invention can be used to fill holes having an opening diameter of 100 micrometers or less and an aspect ratio of 1 or greater, typically 3 or greater, and especially 5 or greater.

This invention can be applied to all metals capable of being electrodeposited, including copper, nickel, gold, silver, palladium, tin, lead, platinum, chromium, zinc, cadmium, iron, aluminum, and alloys of these such as solder.

This invention will be explained below for the case of copper plating. However, this is no more than an example, and is not meant to limit the scope of this invention in any way.

In addition, examples especially ideal for use in copper sulfate plating are given as concrete examples of the grain refiners and surface active agents described below, and the active effects of such substances are explained. However, using compounds presenting the same active effects when electroplating other metals is well-known, and the same effects of this invention are also obtained by systems containing such compounds.

When filling blind via holes by copper plating using the method of this invention, the copper plating solution is typically a copper sulfate plating solution, and preferably contains a grain refiner. However, other copper salts may also be used to prepare the copper plating solution.

Grain refiners are substances having a plus static charge in the plating bath that are adsorbed to the surface of the plating object during electrolysis and desorbed from the surface of the plating object during reverse electrolysis. These substances have an action aiding growth of the metallic film when adsorbed to the surface of the plating object.

Typically, grain refiners are compounds having an intramolecular -S-CH₂O-R-SO₃M structure or compounds having an intramolecular -S-R-SO₃M structure (where M is a hydrogen or alkali metal atom, and R is an alkyl group containing 3 to 8 carbon atoms). Examples of even more typical grain refiners are compounds having the following structures (1) to (6):
(1) M-SO₃-(CH₂)ₐ-S-(CH₂)_{b}-SO₃-M;
(2) (2) M-SO₃-(CH₂)ₐ-O-CH₂-S-CH₂-O-CH₂-SO₃-M;
(3) (3) M-SO₃-(CH₂)ₐ-S-S-CH₂-S-CH₂-SO₃-M;
(4) (4) M-SO₃-(CH₂)ₐ-O-CH₂-S-S-CH₂―(CH₂)_{b}-SO₃-M;
(5) (5) M-SO₃-(CH₂)ₐ-S-C(=S)-S―(CH₂)_{b}-SO₃-M;
(6) (6) M-SO₃-(CH₂)ₐ-O-CH₂-S-C(=S)-S-CH₂-O-(CH₂)_{b}-SO₃-M;

In the above Formulae (1) to (6), a and b = integers from 3 to 8, and M is hydrogen or an alkali metal.

Grain refiners are generally called brighteners and are used to improve the appearance of the deposited metal film, but this invention also includes grain refiners used for other purposes so long as they offer a comparable active effect. Grain refiners may be used alone or as a mixture of two or more types.

Grain refiners can be used in a range such as 0.1 to 100 mg/L, and preferably 0.5 to 10 mg/L. When grain refiners are used for purposes other than to improve the appearance of plating film, the ideal content range is a matter that can be determined as appropriate by persons skilled in the art.

While not wishing to be bound in theory, when using a PPR electrolysis method in which plating is performed while reversing the direction of the current in an extremely short cycle such as used in this invention, the grain refiner is adsorbed to the inner surface of blind via holes in the plating object by electrolysis, and during the short period reverse electrolysis, the grain refiner is desorbed only near the openings of blind via holes where the current tends to accumulate. Therefore, by repeatedly reversing the direction of the current, a large amount of grain refiner is adsorbed near the floors of blind via holes, and a small amount of grain refiner is adsorbed near the openings. As a result, the grain refiner has a stronger action aiding growth of the metal film near the floors of blind via holes, the plating speed near the floors of blind via holes becomes faster than the plating speed near openings, and blind via holes can be filled with a metal deposit without leaving voids.

The electrolytic copper plating solution used in this invention typically contains a surface active agent acting as a lubricant. The surface active agent can be any desired standard surface active agent normally used as an additive in electrolytic copper plating solutions. Preferably, the surface active agent is a polyether containing at least five, and preferably at least twenty, intramolecular ether oxygen atoms. Examples of this type of surface active agent are compounds having the following structures (7) to (9), but are not limited to these:
(7) HO -(CH₂-CH₂-O)ₐ-H (where a = an integer from 5 to 500);
(8) HO -(CH₂-CH(CH₃)-O)ₐ-H (where a = an integer from 5 to 200);
(9) HO -(CH₂-CH₂-O)ₐ-(CH₂-CH(CH₃)-O)_{b}-(CH₂-CH₂-O)_{c}-H (where a and c are integers, a + c = an integer from 5 to 250, and b = an integer from 1 to 100).

The surface active agent used in this invention may be used alone or as a mixture of two or more types. Surface active agents used in this invention can be used in a range of from 0.05 to 10 g/L, and preferably 0.1 to 5 g/L. Lower amounts of surface active agent may be used but may cause many pin-holes in the deposit. Greater amount of surface active agent may be used but such large amount hardly provides any commensurate improvement in effect, making it economically undesirable.

When using a copper sulfate plating solution, the copper sulfate plating solution is an aqueous solution containing a basic composition of sulfuric acid, copper sulfate, and a water-soluble chlorine compound. Said plating solution can use any basic composition without restrictions so long as it is used in standard copper sulfate plating solutions. The concentration of sulfuric acid in the copper sulfate plating solution is normally 30 to 400 g/L, and preferably 170 to 210 g/L. The concentration of copper sulfate in the copper sulfate plating solution is normally 20 to 250 g/L, and preferably 60 to 180 g/L.

The water-soluble chloride compound contained in the copper sulfate plating solution can be any compound without restrictions so long as it is used in standard copper sulfate plating solutions. Examples of said water-soluble chloride compound include hydrochloric acid, sodium chloride, potassium chloride, and ammonium chloride, but are not limited to these. The water-soluble chloride compound may be used alone or as a mixture of two or more types.

The concentration of said water-soluble chloride compound contained in the copper sulfate plating solution, expressed as concentration of chloride ions, is normally 10 to 200 mg/L, and preferably 30 to 80 mg/L.

The substrate supplied to the via filling method of this invention can be a substrate of any desired material and shape so long as it can withstand the conditions of the via filling method and a metal layer can be deposited on it by plating. Examples of materials include resins, ceramics, and metals, but are not limited to these. For example, this method is ideally used for printed circuit board substrates or semiconductor wafers such as silicon wafers. The substrate supplied to this invention is preferably a substrate having through-holes and/or via holes, and more preferably, a printed circuit board or wafer having through-holes and/or via holes.

Examples of resins used as substrates include thermoplastic resins, including polyethylene resins such as high-density polyethylene, medium-density polyethylene, branching low-density polyethylene, straight-chain low-density polyethylene, or super high-molecular-weight polyethylene; polyolefin resins such as polypropylene resin, polybutadiene, polybutene resin, polybutylene resin, or polystyrene resin; halogenated resins such as polyvinyl chloride resin, polyvinylidene chloride resin, polyvinylidene chloride-polyvinyl chloride copolymer resin, chlorinated polyethylene, chlorinated polypropylene, or tetrafluoroethylene; AS resins; ABS resins; MBS resins; polyvinyl alcohol resins; polyacrylic ester resins such as methyl polyacrylate; polymethacrylic ester resins such as methyl polymethacrylate; methyl methacrylate-styrene copolymer resin; maleic anhydride-styrene copolymer resin; polyvinyl chloride resin; cellulose resins such as cellulose propionate resin or cellulose acetate resin; epoxy resins; polyimide resins; polyamide resins such as Nylons; polyamide imide resins; polyallylate resins; polyether imide resins; polyether ether ketone resins; polyethylene oxide resins; polyester resins such as PET resin; polycarbonate resins; polysulfone resins; polyvinyl ether resins; polyvinyl butyral resins; polyphenylene ether resins such as polyphenylene oxide; polyphenylene sulfide resins; polybutylene terephthalate resins; polymethyl pentene resins; polyacetal resins; vinyl chloride-vinyl acetate copolymers; ethylene-vinyl acetate copolymers; ethylene-vinyl chloride copolymers; and copolymers and blends of these; thermosetting resins, including epoxy resins; xylene resins; guanamine resins, diallyl phthalate resins; vinyl ester resins; phenolic resins, unsaturated polyester resins; furan resins; polyimide resins; polyurethane resins, maleic acid resins; melamine resins; and urea resins; and mixtures of these; but are not limited to these. Preferred resins are epoxy resins, polyimide resins, vinyl resins, phenolic resins, Nylon resins, polyphenylene ether resins, polypropylene resins, fluorinated resins, and ABS resins. More preferred resins are epoxy resins, polyimide resins, polyphenylene ether resins, fluorinated resins, and ABS resins. Even more preferred resins are epoxy resins and polyimide resins. In addition, resins substrates may be comprised of a single resin or several resins. The resin substrate may also may be a composite having another resin coated or laminated on the substrate. Moreover, resin substrates that can be used in this invention are not limited to resin molded products, but may be resin composites by way of reinforcing materials, such as materials reinforced by fiberglass between resins, or resin films formed on substrates comprised of other raw materials such as ceramics, glasses, or metals.

Ceramics that can be used as resin materials include oxide ceramics, beginning with alumina (Al₂O₃), steatite (MgO·SiO₂), forsterite (2MgO·SiO₂), mullite (3Al₂O₃·SiO₂), magnesia (MgO), spinel (MgO· Al₂O₃), and beryllia (BeO), non-oxide ceramics such as aluminum nitride or silicon carbonate, and low-temperature sintered ceramics, beginning with glass ceramics, but are not limited to these.

The plating temperature (solution temperature) in the via filling process of this invention is set as appropriate for the type of plating bath, but is normally 10°C to 40°C, and preferably 20°C to 30°C.

Any desired appropriate anode can be used in the via filling process of this invention depending on the type of metal to be plated. Either a soluble anode or an insoluble anode can be used. For example, in the case of copper plating, a phosphated copper anode can be used as a soluble anode, and an anode of a material such as iridium oxide, platinum-clad titanium, platinum, graphite, ferrite, titanium coated with zinc dioxide and a platinic element oxide, or stainless steel can be used as an insoluble anode.

In the via filling process of this invention, preferably, air or oxygen is passed through the plating solution to increase the concentration of dissolved oxygen in the plating solution. Although not wishing to become bogged down in theory, dissolved oxygen in the plating solution is considered to decrease compounds having the structure -X-S- in said plating solution. A preferred method for increasing the concentration of dissolved oxygen in the plating solution is bubbling the plating solution with air or oxygen. Said bubbling may be agitating the plating solution, or bubbling unrelated to agitating. In addition, bubbling to increase the concentration of dissolved oxygen in the plating solution may be applied during electroplating treatment or when electroplating treatment is suspended.

There is no objection to agitating in the via filling process of this invention, and agitating is preferred to supply metal ions and additives evenly to the surface to be plated. Air agitation or a jet spray can be used for the agitation method. Air agitation is preferred from the standpoint of increasing the concentration of dissolved oxygen in the plating solution. Even when agitation by a jet spray is used, preferably, agitating by air is also used. Furthermore, open-change filtration or reflux filtration can also be applied, and reflux filtration of the plating solution by a filter device is especially preferred. Doing this makes the temperature of the plating solution uniform, and can also remove matter such as dirt or sediment in the plating solution.

The via filling process of this invention produces filled vias with no voids.

The case of copper plating was described above, but other metals are plated in the same way as described above. In this case, the method of this invention can be implemented using any desired standard plating solution. The electroplating solution during this can use any basic composition without restrictions so long as it is used in standard electroplating. Moreover, the components of the basic composition can be changed, concentrations can be changed, or additives can be added as appropriate so long as the purposes of this invention are achieved.

This invention will be explained in detail by the following working examples, but such working examples are no more than examples, and do not in any way limit the scope of this invention.

### Example 1

| Plating Solution Composition | |
|---|---|
| CuSO₄·5H₂O | 127.7g/L |
| H₂SO₄ | 213.2 g/L |
| Cl⁻ | 70 mg/L |
| SPS | 4 mg/L |
| nonionic surface active agent | 250 mg/L |
| Note) SPS: disodium bis(3-sulfopropyl)disulfide | |

| Flash Plating | |
|---|---|
| Direct-Current Electrolysis | |
| current density | 2 A/dm² |
| temperature | 20°C |
| time | 11 min |

| Filling Step | |
|---|---|
| current density | 2 A/dm² |
| F/R ratio | 1/0.5 |
| positive electrolysis time | 10 msec |
| reverse electrolysis time | 0.5 msec |
| temperature | 20°C |
| time | 45 minutes |

### Comparative Example

Example 1 was repeated except that the flash plating step was omitted and the following filling step was performed.

| Filling Step | |
|---|---|
| current density | 2 A/dm² |
| F/R ratio | 1/0.5 |
| positive electrolysis time | 10 msec |
| reverse electrolysis time | 0.5 msec |
| temperature | 20°C |
| time | 56 minutes |

The diameter of via was 120 micrometers, and the depth was 60 micrometers.

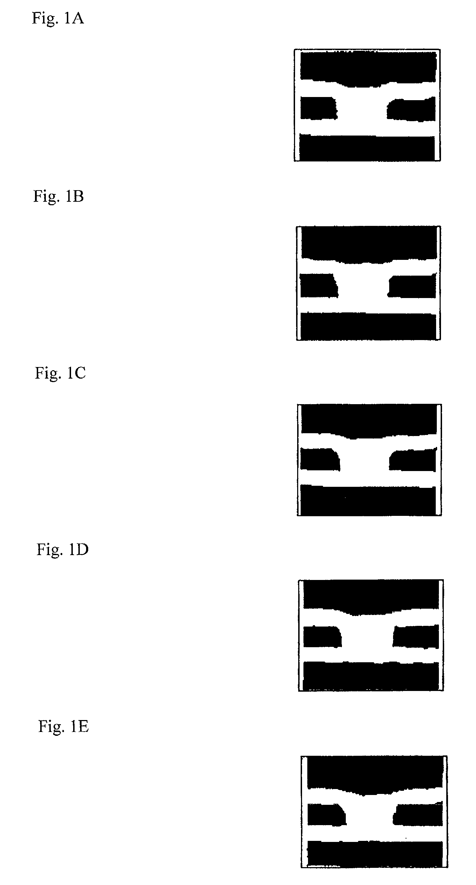

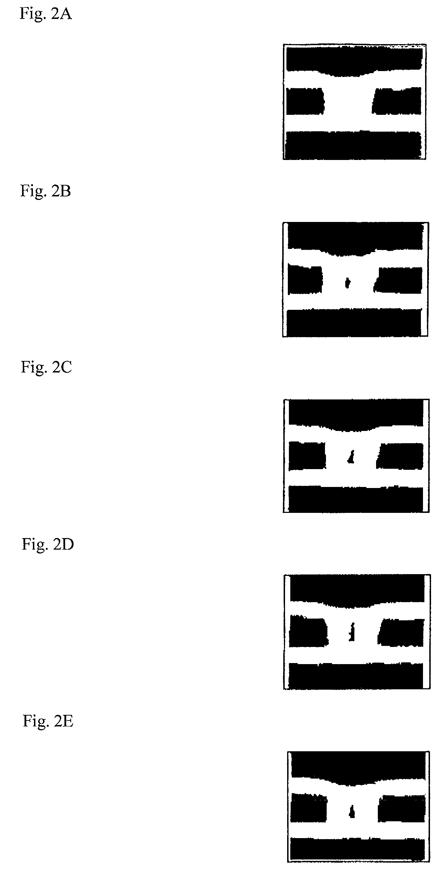

The results of Example 1 show that satisfactory filling was obtained by the via filling method of this invention and that no voids were present in the five vias evaluated by cross-sectional analysis. These results are show in Figs. 1A-1E. The results of the Comparative Example show unsatisfactory filing of the vias, where 4 out of the 5 vias evaluated by cross-sectional analysis contained voids. The comparative results are shown in Figs. 2A-2E.

## Claims

1. A process for filling a via with a metal comprising the steps of flash plating and then applying a PPR current for a cycle of 1 to 50 msec positive electrolysis time and 0.2 to 5 msec reverse electrolysis time such that a F/R ratio representing a ratio of positive electrolysis current density to reverse electrolysis current density is from 1/0.2 to 1/1.

2. The process of claim 1, wherein the flash plating is performed by direct-current electrolysis.

3. The process of claim 1, wherein the flash plating is performed under conditions of applying a PPR current for a cycle of 1 to 50 msec positive electrolysis time and 0.2 to 5 msec reverse electrolysis time until an F/R ratio is 1/1 to 1/10.

4. The process of claim 1, wherein the flash plating is performed by pulse electrolysis.

5. The process of claim 1, wherein the PPR current is applied for a cycle of 1 to 50 msec positive electrolysis time, 0.2 to 5 msec reverse electrolysis time, and 0.1 to 20 msec rest time.

6. The process of claim 1, wherein the metal used for filling is copper.

7. The process of claim 1, wherein the via filling is performed using a metal plating bath containing a grain refiner.

8. The process of claim 1, wherein the via filling is performed using a metal plating bath containing a surface active agent.

9. A printed circuit board containing a via filled by the process of claim 1.

10. A wafer containing a via filled by the process of claim 1.
